# EUROPEAN PATENT SPECIFICATION

(11) **EP 4 046 185 B1**
(45) Date of publication and mention of the grant of the patent: **06.12.2023**
(21) Application number: 20793188.2
(22) Date of filing: 16.10.2020
(51) Int. Cl.: B29C 45/77, B29C 45/78, H01L 21/67, B29C 45/14

(54) **COMPONENT PROCESSING APPARATUS, SUCH AS A PRESSURE SINTERING APPARATUS OR A COMPONENT ENCAPSULATION APPARATUS**
BAUTEILVERARBEITUNGSVORRICHTUNG WIE EINE DRUCKSINTERVORRICHTUNG ODER EINE BAUTEILVERKAPSELUNGSVORRICHTUNG
APPAREIL DE TRAITEMENT DE COMPOSANT TEL QU'UN APPAREIL DE FRITTAGE SOUS PRESSION OU UN APPAREIL D'ENCAPSULATION DE COMPOSANT

(30) Priority: 17.10.2019 NL 2024038
(43) Date of publication of application: 24.08.2022
(73) Proprietor: Boschman Technologies B.V., 6921 EX Duiven (NL)
(72) Inventor: DE BEIJER, Johannes Cornelis, 6921 EX Duiven (NL); BOSCHMAN, Franciscus Gerardus Johannes, 6921 EX Duiven (NL)
(74) Representative: Arnold & Siedsma
(86) International application number: PCT/NL2020/050638
(87) International publication number: WO 2021/075966

(56) References cited:
- EP-A1- 2 954 550
- EP-A1- 3 454 364
- CN-A- 106 482 657

## Description

### FIELD OF THE INVENTION

The invention relates to a component processing apparatus defining at least one component holding position for holding a component, such as comprising a semiconductor die, a substrate, a cooling plate, a package, an inverter casing, a spacer, etcetera, and comprising at least one displaceable member associated with each component holding position, each displaceable member being configured and arranged to allow exerting force on a component held in the associated component holding position. The component processing apparatus can be, for instance, a pressure sintering apparatus or a component encapsulation apparatus.

### BACKGROUND OF THE INVENTION

Pressure sintering of components is done while applying a pressure (exerting a force) on the component to achieve a good bond between the component and its underlying element. A semiconductor die and underlying carrier can, for instance, be bonded together by sintering. Other example are a power IC in a package and an inverter casing or cooling plate to be bonded together, a spacer and substrate to be bonded, etcetera. Multiple types of components and underlying elements can be bonded together by a pressure sintering process. Initially, the components to be sintered are placed onto their underlying element with a sintering paste, film, dispensed fluid or the like, such as a silver paste, film, dispensed fluid or the like, in between component and underlying element. Subsequently, a pressure is applied using, for instance, displaceable members that each exert a pressure on an associated component, while generally the components and underlying elements are heated. A processing apparatus employing displaceable inserts (displaceable members) is disclosed in WO 2014/123413 A1. The displaceable inserts/members allow for variation in heights and unevenness of the components to be sintered, but can also be employed in other manners in the apparatus for exerting a pressure on the components. The displaceable inserts can be arranged above the components to apply a downwards pressure, be arranged below the components to apply an upwards pressure, or both above and below the components to apply a pressure from both sides by the displaceable inserts. Generally, the component might be referred to as underlying element and the underlying element as component as well, since component and element are pressure bonded together. For the present description it has been chosen to refer to component as the part that is associated with a displaceable insert by corresponding size or location. In some embodiments both parts to be pressure bonded could be referred to as component or underlying element.

Another type of apparatus that may employ displaceable inserts concerns an encapsulation or packaging apparatus used for encapsulating or packaging components, such as semiconductor dies, a substrate, a cooling plate, a package, an inverter casing, a spacer, etcetera, and assemblies thereof. The component is held in a space of the apparatus and an encapsulation material is introduced into the space in a liquid state. The encapsulation material is allowed to solidify, while a pressure is being exerted onto the component using a displaceable member to prevent a surface area of the component to come into contact with the encapsulation material. This allows the component to be encapsulated by the encapsulation material while leaving part of the component uncovered.

The components to be encapsulated or sintered may additionally concern chips, sensors, power ICs, flip chips, MEMs, etcetera. For manufacturing, failure and reliability analysis and prediction it is very important that the pressure exerted on the component during the sintering process, encapsulation process, or any other process in which a pressure is exerted on a component while processing, is known or monitored. Especially, when using displaceable members for exerting a pressure, it is very important to verify in real time the pressure exerted. It might occur that a movable member experiences a malfunction due to a failure in force generation. The displaceable member may, for instance, get stuck during the process sequence. For the purpose of feedback control, it may be very important as well to have the real time pressure exerted available. Sensors applied for this purpose must be very compact, accurate and suitable for the conditions at hand, such high pressure and/or high temperature. Presently applied sensors have their disadvantages in this regard.

Document EP 2954550 A1 discloses a semiconductor die encapsulation or carrier mounting method, and an associated semiconductor die encapsulation or carrier mounting apparatus.

As an additional prior art illustration are also mentioned the following documents:
CN 106482657 A1
EP 3454364 A1

### SUMMARY OF THE INVENTION

It is an objective of the invention to provide a component processing apparatus that provides for enhanced control and process optimization and/or for enhanced risk control.

It is another or alternative objective of the invention to provide a component processing apparatus providing good malfunction detection.

It is yet another or alternative objective of the invention to provide a component processing apparatus providing an accurate and/or reliable monitoring of pressure and optionally temperature process conditions, especially very close to the actual process region, i.e. sintering or encapsulation/molding region.

It is yet another or alternative objective of the invention to provide a component processing apparatus that allows real-time measuring pressure and optionally temperature process conditions, especially very close to the actual process region, i.e. sintering or encapsulation/molding region.

At least one of the above objectives is achieved by a component processing apparatus defining at least one component holding position for holding a component, such as comprising a semiconductor die, a substrate, a cooling plate, a package, an inverter casing, a spacer, etcetera, and comprising at least one displaceable member associated with each component holding position, each displaceable member being configured and arranged to allow exerting force on a component held in the associated component holding position,
the component processing apparatus comprising at least one apparatus part that is susceptible to strain induced by force, in use, exerted by the at least one displaceable member on the respective component(s) held in the component holding position(s), and that has a Fiber Bragg Grating, FBG, strain sensor, wherein the FBG strain sensor is configured and arranged mechanically attached to the respective apparatus part to allow measuring strain of the respective apparatus part as induced by force, in use, exerted by the at least one displaceable member on the respective component(s).

The FBG strain sensor allows integration into the respective apparatus part without compromising the basic functioning aspects of the processing apparatus, while providing a reliable and accurate strain measurement under actual process conditions. It is referred to as a strain sensor since a measuring signal from the FBG strain sensor is dependent on a strain in the respective apparatus part and the FBG strain sensor due to their mechanical connection. The strain measurement has shown to have a well-defined dependence on the force exerted by the displaceable member(s) on the respective component(s). An FBG sensor is very compact, accurate and suitable for process conditions at applicable pressures and temperatures for processes such as press sintering and component packaging or encapsulation.

In an embodiment at least one of the at least one apparatus part having the FBG strain sensor has a Fiber Bragg Grating, FBG, temperature sensor, and wherein the FBG temperature sensor is configured and arranged thermally in contact with the respective apparatus part to allow measuring temperature of the respective apparatus part while not being susceptible to strain in the respective apparatus part, especially the FBG temperature sensor being arranged mechanically isolated from the respective apparatus part.

The FBG temperature sensor is referred to as a temperature sensor since a measuring signal from the FBG temperature sensor is dependent on a temperature in the respective apparatus part and the FBG temperature sensor due to their thermal contact, but not dependent on strain in the respective apparatus part due to the mechanical isolation of the FBG temperature sensor from the respective apparatus part. Additionally measuring the temperature of the respective apparatus part allows monitoring a process temperature and correcting a measurement signal from the FBG strain sensor for any influence due to temperature change on the FBG strain sensor. The latter allows a strain measurement of the respective apparatus part by the FBG strain sensor, which is at least largely independent of temperature and at least predominantly dependent on strain.

In an embodiment the FBG strain sensor has been mechanically attached to said respective apparatus part by a pressureless sintering process, which provides an reliable mechanical bond between an FBG sensor and the respective apparatus part. The pressureless sintering process providing the sintering bond is shown to influence the measuring characteristics of the FBG sensor.

In an embodiment at least one of the FBG strain sensor and an applicable section of said respective apparatus part have been coated with a material comprising a precious metal, like silver or gold, optionally a silver or gold sintering paste, and subsequently heated for providing a pressureless sinter bond between the FBG strain sensor and said respective apparatus part.

In an embodiment the FGB strain sensor is arranged in a channel provided in said respective apparatus part.

In an embodiment the FGB temperature sensor is arranged in a channel provided in said respective apparatus part.

In an embodiment the channel is a groove provided at a side of said respective apparatus part.

In an embodiment said respective apparatus part comprises two sub apparatus parts having mutually abutting sides provided with matching grooves providing the channel.

In an embodiment the at least one apparatus part having the FBG strain sensor comprises one or more of the at least one displaceable member.

In an embodiment the at least one apparatus part having the FBG strain sensor comprises a support part of a support for the components.

In an embodiment the FBG strain sensor and the FBG temperature sensor that are provided in a single respective apparatus part are comprised in a single optical fiber.

In an embodiment the component processing apparatus comprises
- a component holding tool part defining the at least one component holding position for holding a component; and
- at least one pressure tool part comprising the at least one displaceable member,
the component processing apparatus being configured to have or allow to have the component holding tool part and the pressure tool part positioned with respect to one another for exerting, in operation, force onto the at least one component held in the respective component holding position(s) by the at least one displaceable member.

The pressure tool part is referred to as a pressure tool part, since it allows exerting a force (equivalent to exerting/applying a pressure) onto the component(s) held on the component holding tool part.

In an embodiment the component holding tool part is configured for holding an underlying element, such as a carrier substrate, lead frame, cooling plate, inverter casing, etcetera, carrying the at least one component.

In an embodiment the component processing apparatus comprises a top pressure tool part and a bottom pressure tool part arranged on opposing sides of the component holding tool part to allow exerting force onto a respective one of the at least one components held in a respective component holding position on the component tool part onto opposing sides of said respective one component by opposing displaceable members of the top and bottom pressure tool parts, respectively.

In another aspect the invention provides for a pressure sintering apparatus, wherein the pressure sintering apparatus is the component processing apparatus as referred to above.

In another aspect the invention provides for a component encapsulation apparatus, wherein the component encapsulation apparatus is a component processing apparatus as referred to above. A component encapsulation apparatus is also referred to as a (component) packaging apparatus.

### BRIEF DESCRIPTION OF THE DRAWINGS

Further features and advantages of the invention will become apparent from the description of the invention by way of non-limiting and non-exclusive embodiments. These embodiments are not to be construed as limiting the scope of protection. The person skilled in the art will realize that other alternatives and equivalent embodiments of the invention can be conceived and reduced to practice without departing from the scope of the present invention which is defined by the appended claims. Embodiments of the invention will be described with reference to the accompanying drawings, in which like or same reference symbols denote like, same or corresponding parts, and in which
Figures 1a and 1b show embodiments of a component processing apparatus according to the invention in the form of a pressure sintering apparatus;
Figures 2a and 2b show embodiments of a displaceable member of the apparatus of figure 1;
Figures 3a and 3b show yet another embodiment of a displaceable member of the apparatus of figure 1;
Figure 4a shows an example of an FBG sensor for schematically explaining its operation;
Figures 4b, 4c and 4d show input, reflected and transmitted light intensity spectra, respectively, as applicable for the example FBG sensor of figure 4a;
Figures 5, 6 and 7 show yet further embodiments of a component processing apparatus according to the invention in the form of a pressure sintering apparatus; and
Figure 8 shows yet another embodiment of a component processing apparatus according to the invention in the form of a component packaging or encapsulation apparatus.

### DETAILED DESCRIPTION OF EMBODIMENTS

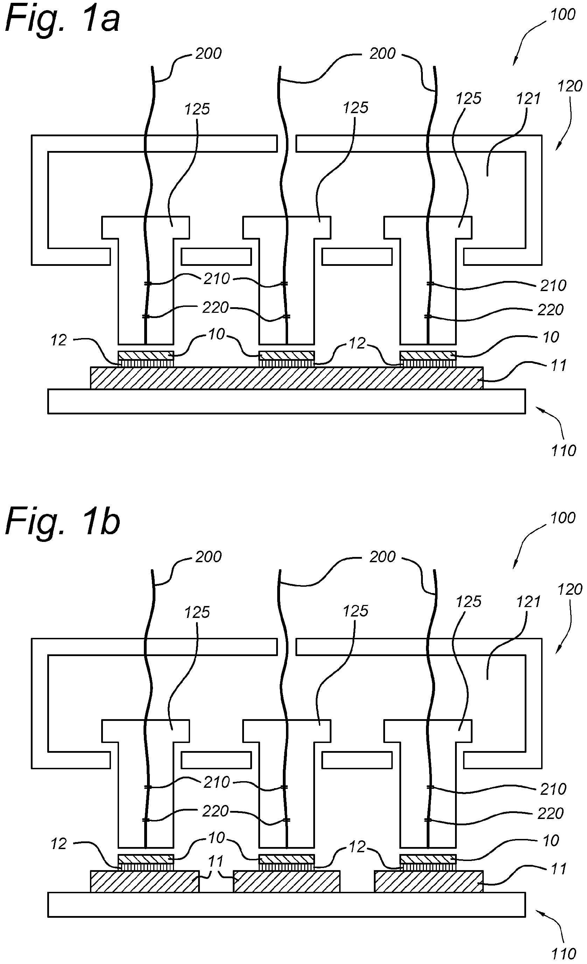

Figure 1a schematically shows a component processing apparatus 100 according to an embodiment of the invention. The component processing apparatus shown in figure 1a is a pressure sintering apparatus comprising a component holding tool part 110 and a pressure tool part 120 having displaceable members (displaceable inserts) 125. An underlying element 11, such as a component carrier or lead frame, carrying components 10 thereon has been provided on the component holding tool part. A sintering paste 12 is present between each component 10 and the component carrier 11. One component carrier carrying multiple components is provided in the embodiment of figure 1a as the underlying element. The apparatus layout is such that the components carried on their component carrier are provided at predefined component holding positions. The positions of the displaceable members 125 are associated with the respective component holding positions. The embodiment of figure 1b is largely the same as the one of figure 1a but shows that each component 10 is provided on a separate underlying element 11.

The component holding tool part 110 and the pressure tool part 120 have generally been moved apart from one another while the component carrier 110 with components 10 is provided onto the component holding tool part 110. The component holding part 110 and the pressure tool part 120 are then moved towards one another. They may be move towards one another until the displaceable members 125 of the pressure tool part 120 touch their respective associated components 10, or both tool parts 110, 120 may be moved towards each other to leave a gap between the displaceable members 125 and their respective associated components 10. Alternatively, the component carrier 11 carrying components 10 may be moved in between stationary component holding tool part 110 and pressure tool part 120 while having a gap between displaceable members 125 and components 10.

Subsequently, the displaceable members 125 are activated for applying a pressure (applying a pressure and exerting a force are to be understood as being equivalent) on their respective associated components 10. The embodiment depicted in figure 1 shows a pressure chamber 121 that is pressurized to drive the displaceable members towards their respective associated components. Alternative embodiments can employ any other means for displacing the displaceable members 125, such as by, for instance, electric actuation. The components 10 are generally heated for sintering the sintering material 12 and to achieve a bond between the components 10 and their component carrier 11. Heating can be achieved in various ways, for instance, by heating elements provided in the component support tool part 110, in the pressure tool part 120, and/or in the displaceable members 125. A time-dependent temperature profile may be applied during the pressure sintering process, and the pressure applied may be set as a function of time and/or temperature.

An optical fiber 200 is provided in each displaceable member 125. Each optical fiber 200 comprises an FBG strain sensor 210 and an FBG temperature sensor 220. The FBG strain sensor 210 is configured and arranged for measuring the strain induced in the respective displaceable member 125 while exerting a force onto the associated component 10. The FBG temperature sensor is configured and arranged for measuring the temperature of the respective displaceable member 125. Both the FBG strain sensor 210 and the FBG temperature sensor 220 can be a same type of FBG sensor, but they differ in the way that they are provided on the displaceable member 125. The FBG strain sensor 210 is mechanically attached to the displaceable member 125, which implies that any mechanical strain in the displaceable member is induced in the FBG strain sensor 210 as well. The FBG strain sensor is provided such on the displaceable member that the strain induced by applying a force on the respective component 10 is measurable with the FBG strain sensor. This means that the grating provided in the FBG strain sensor is oriented to allow measuring a signal with the FBG strain sensor that is dependent on the strain induced in the displaceable member. The grating of the FBG strain sensor 210 in the fiber 200 has its grating period along the optical fiber. The grating period therefore varies as function of the strain induced in the displaceable member 125 while exerting a force on a respective component 10, which as a result provides a related variation in signal measured using the FBG strain sensor 210.

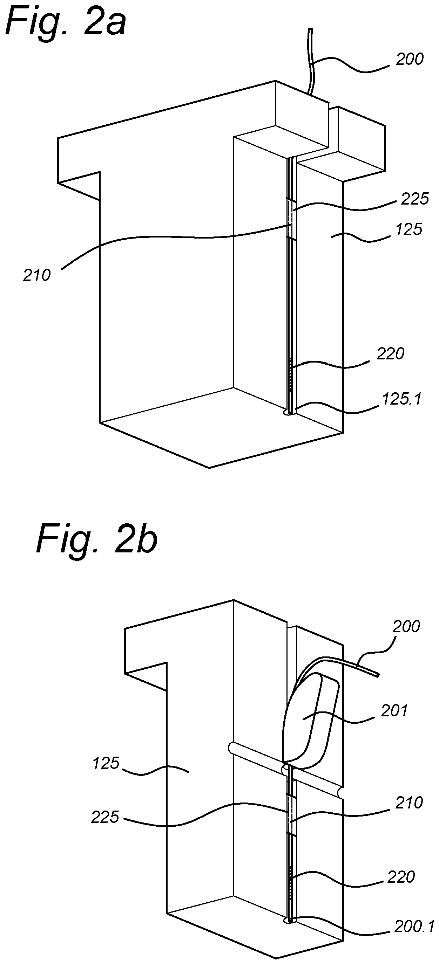

The part of the optical fiber 200 having the FBG strain sensor 210 has been mechanically attached to the displaceable member 125 by a pressureless sintering process. Figures 2a and 2b show embodiments of a displaceable member 125 of figure 1 in more detail. A channel 125.1 in the form of a groove has been made in a side of the displaceable member. To achieve the mechanical attachment between the (part of the fiber 200 having the) FBG strain sensor 210 and the displaceable member 125 the FBG strain sensor and/or the section of the groove in which the FBG strain sensor 210 is to be provided is/are coated with a sintering paste, such as a silver sintering paste, after which the FBG strain sensor is put into the groove. Subsequently, the displaceable member is heated for sintering the paste to solidify and provide a mechanical connection between the FBG strain sensor and the displaceable member. The embodiments of figures 2a and 2b are somewhat different in their layout and guidance of the optical fiber 200, the embodiment of figure 2b having and fiber guide 201 for guiding the optical fiber 200 sideways.

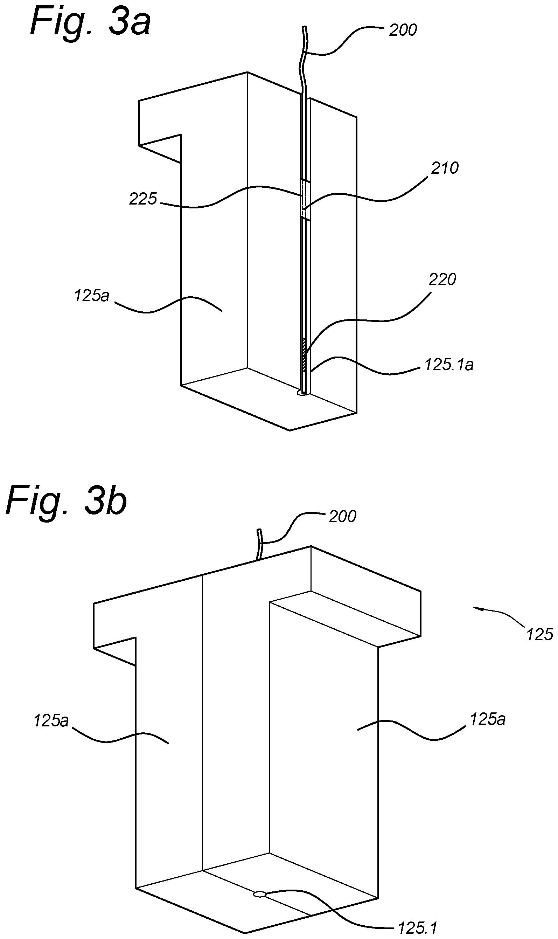

Figures 3a and 3b show yet another embodiment of the displaceable member of the apparatus shown in figure 1. The displaceable member 125 is made in two halves 125a, both having a groove 125.1a in their mutually abutting sides. Both grooves 125.1a make up a channel 125.1 when both halves 125a are put together to form the displaceable member 125. Before both halves are put together, a sintering paste is provided on at least one of the FBG strain sensor 210 and one or both of the sections of the grooves 125.1a in which the FBG strain sensor is to be provided. The (part of the fiber 200 having the) FBG strain sensor is put in one of the grooves 125.1a and both halves are put together, after which the displaceable member is heated to provide mechanical attachment by a mechanical bond between the FBG sensor and the displaceable member. The bond provided by the sintering process as described with reference to figures 2a, 2b, 3a and 3b does not provide any strain on the FBG strain sensor, but does give a good mechanical connection between FBG strain sensor 210 and displaceable member 125. The bond provides a thermal connection between FBG strain sensor and displaceable member as well.

The FBG temperature sensor 220 is provided such on the displaceable member that it is not susceptible to strain in but in thermal contact with the displaceable member 125. The FBG temperature sensor 220 is arranged mechanically isolated from the displaceable member 125. Figures 2a, 2b, 3a and 3b also show the FBG temperature sensor 220, which is provided in the channel 125.1 of the displaceable member as well. The (part of the fiber 200 having the) FBG temperature sensor 220 is provided free hanging in the channel 125.1 below the FBG strain sensor 210 in the embodiments shown. Since the FBG temperature sensor is in the channel 125.1 closely surrounded by the displaceable member 125, it is in thermal radiation contact with the displaceable member and will take the temperature of the displaceable member at that position. In an alternative embodiment, the FBG temperature sensor 220 may by attached to the displaceable member using a suitable material that provides mechanical isolation but good thermal contact and can withstand the temperatures employed when the apparatus 100 is operated. An appropriate kit that remains resilient at the temperatures at hand could be suitable for that purpose.

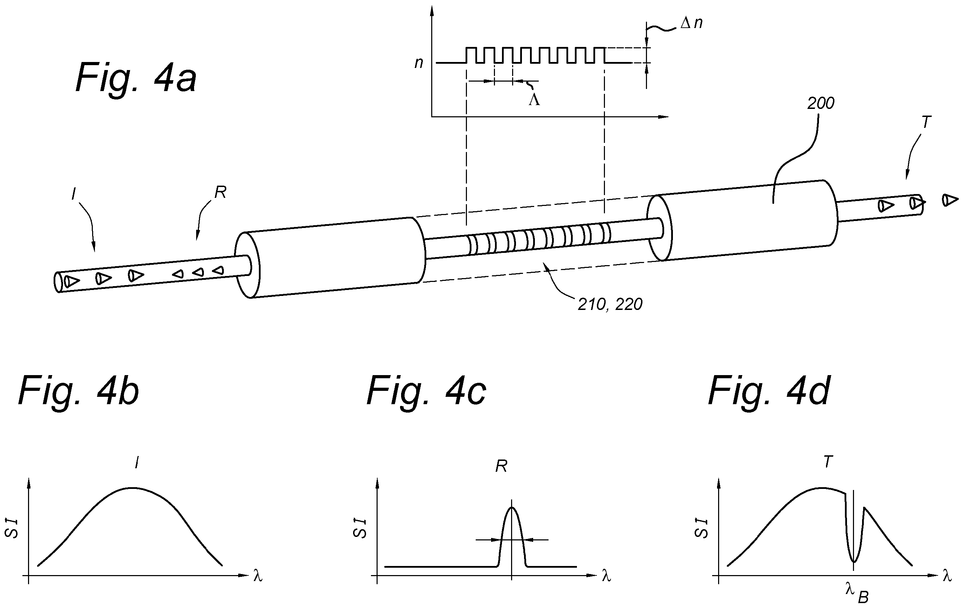

Figures 4a to 4d depict the principle of operation of a general Fiber Bragg Grating, FBG, sensor. Figure 4a shows the FBG sensor, which is indicated by same reference numerals 210, 220 as used to indicate the FBG strain and temperature sensors in the other figures. The FBG sensor is a grating or grid provided in the fiber 200 as a result of a variation Δn in the refractive index n of the core of the fiber. The grating or grid has a grid period Λ. Figure 4b shows the spectral intensity SI of input light I as a function of wavelength λ on the grid of the FBG sensor when employing the FBG sensor. Some of the input light I is reflected back by the grid as reflected light R at the Bragg wavelength λB given by the grid period Λ as shown in figure 4c. The transmitted light T shows as a dip in the spectral intensity SI of the transmitted light T at the Bragg wavelength λB as depicted in figure 4d. The Bragg wavelength λB is dependent on the grid period Λ. The grid period will change with strain induced in the FBG sensor 210, 220 in the fiber 200 and with temperature of the of the FBG sensor. Therefore, the Bragg wavelength λB will change as a function of strain and temperature of the FBG sensor. Measurement of the Bragg wavelength λB will therefore provide an indication of strain and temperature of the FBG sensor. Only the general principles of the FBG sensors are disclosed. Their operation is known as such. Some principles of their operation are disclosed in, for instance, EP 2 811 257 A1 and EP 3 144 633 B1.

The FBG temperature sensor 220 is provided such on respective displaceable members 125 that it does not experience any strain. The Bragg wavelength of the FBG temperature sensor 220 will therefore provide a measure of the temperature of the displaceable member 125 and the respective component 10. The FBG strain sensor 210 is provided such on the displaceable member 125 that it will experience the strain in the displaceable member 125, which will affect the Bragg wavelength of the FBG strain sensor 210. Additionally, the FBG strain sensor 210 will be at the temperature of the displaceable member 125. Therefore, the Bragg wavelength of the FBG strain sensor 220 will be dependent on both the strain and the temperature of the FBG strain sensor. Since the temperature of the displaceable member is known from the Bragg wavelength shift of the FBG temperature sensor 220, the Bragg wavelength shift of the FBG strain sensor 210 can be corrected for the wavelength shift due to temperature change, so that the strain of the FBG strain sensor can be determined from the signal reading of the FBG strain sensor. In case the temperature would be kept constant in a component processing process and apparatus, only an FBG strain sensor is required to determine the strain of the FBG strain sensor and the displaceable member, or any other machine part in which the FBG strain sensor would be employed.

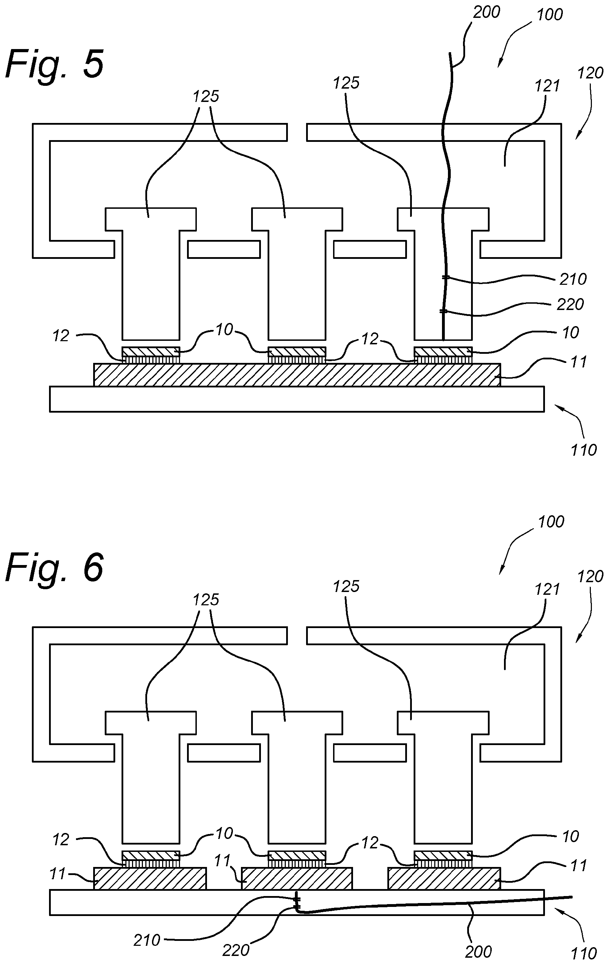

Figure 5 shows another embodiment of a component processing apparatus 100 according to the invention as a pressure sintering apparatus. The embodiment of figure 5 differs from the embodiment of figure 1 in that not all displaceable members 125 are provided with an FBG strain sensor 210 and an FBG temperature sensor 220. Only one displaceable member 125 is shown to have a fiber 200 with an FBG strain sensor 210 and an FBG temperature sensor 220. The one displaceable member having FBG strain and temperature sensors represents an embodiment in which the FBG strain and temperature sensors are only integrated in displaceable members at strategic locations, for instance at the corners and/or center of an array of displaceable members employed in the component processing apparatus. In another embodiment both FBG strain and temperature sensors are employed in one or more displaceable members at strategic locations, while some other displaceable members have only an FBG strain sensor.

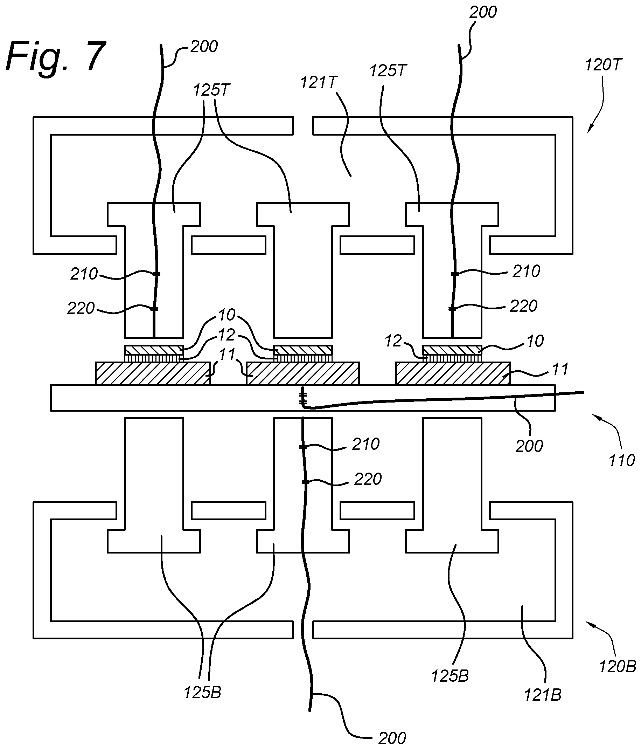

Figure 6 shows yet another embodiment of a component processing apparatus 100 according to the invention as a pressure sintering apparatus. The embodiment of figure 6 has an FBG strain sensor 210 and an FBG temperature sensor 220, both provided in a single optical fiber 200, in the component holding tool part 110. The FBG strain and temperature sensors 210, 220 of the embodiment of figure are employed in a same manner as disclosed with reference to figure 1. However, a measure of the total integrated force exerted by all displaceable members 125 onto their associated components 10 is provided. A failure of one or more of the displaceable members can thus be detected when the strain as measured deviates from a strain as expected when all displaceable members would exert their required force on their associated components. Any applicable combination of the embodiments of figures 1, 5 and 6 can be envisaged as well, such as having FBG strain and temperature sensors in a support, such as the component holding tool part 110, for the components 10, and FBG strain and temperature sensors in only some displaceable members. The embodiment of figure 6, and also the embodiment of figure 7, shows that each component 10 is provided on a separate underlying element 11, such as, for instance, a packaged inverter to be pressure sintered onto a cooling plate. Both the packaged inverter and the cooling plate of the embodiments of figures 6 and 7 could be considered as the component associated with the displaceable member 125 for the purposes of the present description.

Figure 7 shows yet another embodiment of a component processing apparatus 100 according to the invention as a pressure sintering apparatus. The component processing apparatus 100 of figure 7 has a top pressure tool part 120T having displaceable members 125 and a bottom pressure tool part 120B having displaceable members 125. The top and bottom pressure tool parts 120T, 120B are arranged above and below the component holding tool part 110, respectively. A pressure is exerted on a component 10, held in a respective component holding position, by an associated top displaceable member 125T and an associated bottom displaceable member 125B. Having top and bottom displaceable members allows for a more advanced and accurate pressure (or force) control on a component 10 and its underlying element 12. The embodiment of figure 7 has an FBG strain sensor 210 and an FBG temperature sensor 220 only in some displaceable members 125T, 125B and in the component holding tool part 110.

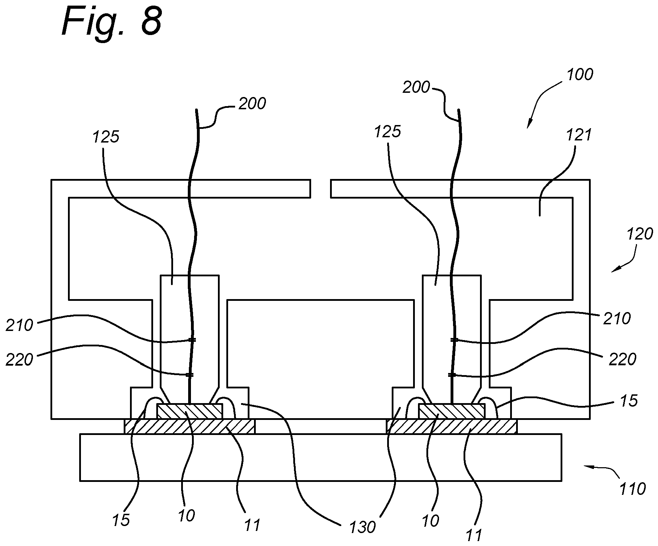

Figure 8 shows yet another embodiment of a component processing apparatus 100 in the form of a packaging or component encapsulation apparatus. Components 10, for instance semiconductor dies, are provided on respective underlying elements 11 that are held on a component holding tool part 110. Contact wires 15 are provided from the component to contact areas of the underlying element. The components are held at respective component holding positions that are associated with respective displaceable members 125 of a pressure tool part 120. In operation the pressure and component holding tool parts 120, 110 are brought together such as to define a cavity 130 between the tool parts. The cavity 130 is filled with a packaging material that is fluid at elevated temperatures and solidifies when the temperature is lowered to encapsulate (package) the component 10 as defined by the cavity 130. Figure 7 only schematically shows the component encapsulation apparatus. EP 2 954 550 A1, for instance, discloses embodiments of an encapsulation method and apparatus. The displaceable members 125 press on their respective components to prevent a surface area of the component to become covered by the packaging material. A suitable material film may generally be provided over the side of the pressure tool part 120, including the displaceable members 125, facing the component 10. The pressure should be sufficient to prevent encapsulation (packaging) material to come between the displaceable member 125 and the component 10. The force exerted by the displaceable member may be varied in dependence of temperature and pressure of the liquid packaging material in the cavity 130. The component 10 is thus bonded to its underlying element 11 for providing a packaged component. An FBG strain sensor 210 and an FBG temperature sensor 220, provided in a single fiber 200, are arranged on each displaceable member in a manner as has been described with reference to figures 1, 2a, 2b, 3a and 3b. The FBG strain and temperature sensors 210, 220 may also be arranged as has been disclosed with reference to figures 5, 6 and 7.

## Claims

1. A component processing apparatus (100) defining at least one component holding position for holding a component (10), such as comprising at least one of a semiconductor die, a substrate, a cooling plate, a package, an inverter casing, a spacer, and comprising at least one displaceable member (125) associated with each component holding position, each displaceable member being configured and arranged to allow exerting force on a component held in the associated component holding position, the component processing apparatus (100) being **characterized in that**:
it is comprising at least one apparatus part that is susceptible to strain induced by force, in use, exerted by the at least one displaceable member on the respective component(s) held in the component holding position(s), and that has a Fiber Bragg Grating, FBG, strain sensor (210), wherein the FBG strain sensor is configured and arranged mechanically attached to the respective apparatus part to allow measuring strain of the respective apparatus part as induced by force, in use, exerted by the at least one displaceable member on the respective component(s).

2. The component processing apparatus according to the preceding claim, wherein at least one of the at least one apparatus part having the FBG strain sensor (210) has a Fiber Bragg Grating, FBG, temperature sensor (220), and wherein the FBG temperature sensor is configured and arranged thermally in contact with the respective apparatus part to allow measuring temperature of the respective apparatus part while not being susceptible to strain in the respective apparatus part, especially the FBG temperature sensor being arranged mechanically isolated from the respective apparatus part.

3. The component processing apparatus according to any one of the preceding claims, wherein the FBG strain sensor (210) has been mechanically attached to said respective apparatus part by a pressureless sintering process.

4. The component processing apparatus according to the preceding claim, wherein at least one of the FBG strain sensor (210) and an applicable section of said respective apparatus part have been coated with a material comprising a precious metal, like silver or gold, optionally a silver or gold sintering paste or film, and subsequently heated for providing a pressureless sinter bond between the FBG strain sensor and said respective apparatus part.

5. The component processing apparatus according to any one of the preceding claims, wherein the FGB strain sensor (210) is arranged in a channel (125.1) provided in said respective apparatus part.

6. The component processing apparatus according to any one of the preceding claims as dependent on claim 2, wherein the FGB temperature sensor (220) is arranged in a channel (125.1) provided in said respective apparatus part.

7. The component processing apparatus according to any one of the preceding two claims, wherein the channel (125.1) is a groove provided at a side of said respective apparatus part,
optionally wherein said respective apparatus part comprises two sub apparatus parts having mutually abutting sides provided with matching grooves (125.1a) providing the channel (125.1).

8. The component processing apparatus according to any one of the preceding claims, wherein the at least one apparatus part having the FBG strain sensor (210) comprises one or more of the at least one displaceable member (125).

9. The component processing apparatus according to any one of the preceding claims, wherein the at least one apparatus part having the FBG strain sensor (210) comprises a support part of a support for the components.

10. The component processing apparatus according to any one of the preceding claims as dependent on claim 2, wherein the FBG strain sensor (210) and the FBG temperature sensor (220) that are provided in a single respective apparatus part are comprised in a single optical fiber (200).

11. The component processing apparatus according to any one of the preceding claims, wherein the component processing apparatus comprises
- a component holding tool part (110) defining the at least one component holding position for holding a component; and
- at least one pressure tool part (120) comprising the at least one displaceable member (125),
the component processing apparatus being configured to have or allow to have the component holding tool part and the pressure tool part positioned with respect to one another for exerting, in operation, force onto the at least one component (10) held in the respective component holding position(s) by the at least one displaceable member.

12. The component processing apparatus according to the preceding claim, wherein the component holding tool part (110) is configured for holding an underlying element (11), such as a carrier substrate, lead frame, cooling plate, inverter casing, etcetera, carrying the at least one component (10).

13. The component processing apparatus according to any one of the preceding two claims, wherein the component processing apparatus comprises a top pressure tool part (120T) and a bottom pressure tool part (120B) arranged on opposing sides of the component holding tool part (110) to allow exerting force onto a respective one of the at least one components held in a respective component holding position on the component tool part onto opposing sides of said respective one component by opposing displaceable members (125T, 125B) of the top and bottom pressure tool parts, respectively.

14. A pressure sintering apparatus, wherein the pressure sintering apparatus is the component processing apparatus according to any one of the preceding claims.

15. A component encapsulation apparatus, wherein the component encapsulation apparatus is the component processing apparatus according to any one of the preceding claims.

## Patentansprüche

1. Bauteilverarbeitungsvorrichtung (100), die mindestens eine Bauteilhalteposition zum Halten eines Bauteils (10) definiert, das beispielsweise mindestens einen Halbleiterchip, ein Substrat, eine Kühlplatte, ein Gehäuse, ein Invertergehäuse oder einen Abstandshalter umfasst, und das mindestens ein verschiebbares Element (125) umfasst, das jeder Bauteilhalteposition zugeordnet ist, wobei jedes verschiebbare Element so konfiguriert und angeordnet ist, dass es die Ausübung einer Kraft auf ein in der zugeordneten Bauteilhalteposition gehaltenes Bauteil ermöglicht,
wobei die Bauteilbearbeitungsvorrichtung (100) **dadurch gekennzeichnet ist, dass**:
sie mindestens ein Vorrichtungsteil umfasst, das für eine Dehnung empfindlich ist, die durch eine Kraft induziert wird, die im Gebrauch durch das mindestens eine verschiebbare Element auf die jeweilige(n) Komponente(n) ausgeübt wird, die in der (den) Komponentenhalteposition(en) gehalten wird (werden), und das einen Faser-Bragg-Gitter, FBG, -Dehnungssensor (210) aufweist, wobei der FBG-Dehnungssensor so konfiguriert und angeordnet ist, dass er mechanisch an dem jeweiligen Vorrichtungsteil angebracht ist, um eine Messung der Dehnung des jeweiligen Vorrichtungsteils zu ermöglichen, die durch eine Kraft induziert wird, die im Gebrauch durch das mindestens eine verschiebbare Element auf die jeweilige(n) Komponente(n) ausgeübt wird.

2. Bauteilbearbeitungsvorrichtung nach dem vorhergehenden Anspruch,
wobei mindestens eines des mindestens einen Vorrichtungsteils mit dem FBG-Dehnungssensor (210) einen Faser-Bragg-Gitter, FBG, -Temperatursensor (220) aufweist, und wobei der FBG-Temperatursensor so konfiguriert und angeordnet ist, dass er thermisch in Kontakt mit dem jeweiligen Vorrichtungsteil steht, um eine Messung der Temperatur des jeweiligen Vorrichtungsteils zu ermöglichen, während er unempfindlich gegenüber Dehnungen in dem jeweiligen Vorrichtungsteil ist, wobei insbesondere der FBG-Temperatursensor mechanisch isoliert von dem jeweiligen Vorrichtungsteil angeordnet ist.

3. Bauteilbearbeitungsvorrichtung nach einem der vorhergehenden Ansprüche, wobei der FBG-Dehnungssensor (210) durch ein druckloses Sinterverfahren mechanisch mit dem jeweiligen Vorrichtungsteil verbunden ist.

4. Bauteilbearbeitungsvorrichtung nach dem vorhergehenden Anspruch,
wobei der FBG-Dehnungssensor (210) und/oder ein anwendbarer Abschnitt des jeweiligen Vorrichtungsteils mit einem Material beschichtet worden ist, das ein Edelmetall, wie Silber oder Gold, optional eine Silber- oder Goldsinterpaste oder -folie, umfasst, und anschließend erhitzt worden ist, um eine drucklose Sinterverbindung zwischen dem FBG-Dehnungssensor und dem jeweiligen Vorrichtungsteil bereitzustellen.

5. Bauteilbearbeitungsvorrichtung nach einem der vorhergehenden Ansprüche, wobei der FBG-Dehnungssensor (210) in einem im jeweiligen Vorrichtungsteil vorgesehenen Kanal (125.1) angeordnet ist.

6. Bauteilbearbeitungsvorrichtung nach einem der vorhergehenden Ansprüche in Abhängigkeit von Anspruch 2, wobei der FGB-Temperatursensor (220) in einem im jeweiligen Vorrichtungsteil vorgesehenen Kanal (125.1) angeordnet ist.

7. Bauteilbearbeitungsvorrichtung nach einem der beiden vorhergehenden Ansprüche, wobei der Kanal (125.1) eine Nut ist, die an einer Seite des jeweiligen Vorrichtungsteils vorgesehen ist,
optional, wobei das jeweilige Vorrichtungsteil zwei Untervorrichtungsteile umfasst, deren aneinanderstoßende Seiten mit passenden Nuten (125.1a) versehen sind, die den Kanal (125.1) bilden.

8. Bauteilbearbeitungsvorrichtung nach einem der vorhergehenden Ansprüche, wobei das mindestens eine Vorrichtungsteil mit dem FBG-Dehnungssensor (210) ein oder mehrere des mindestens einen verschiebbaren Elements (125) umfasst.

9. Bauteilbearbeitungsvorrichtung nach einem der vorhergehenden Ansprüche, wobei das mindestens eine Vorrichtungsteil mit dem FBG-Dehnungssensor (210) ein Trägerteil eines Trägers für die Bauteile umfasst.

10. Bauteilbearbeitungsvorrichtung nach einem der vorhergehenden Ansprüche in Abhängigkeit von Anspruch 2, wobei der FBG-Dehnungssensor (210) und der FBG-Temperatursensor (220), die in einem einzigen jeweiligen Vorrichtungsteil vorgesehen sind, in einer einzigen optischen Faser (200) enthalten sind.

11. Bauteilbearbeitungsvorrichtung nach einem der vorhergehenden Ansprüche, wobei die Bauteilbearbeitungsvorrichtung Folgendes umfasst
- ein Bauteilhaltewerkzeugteil (110), das die mindestens eine Bauteilhalteposition zum Halten eines Bauteils definiert, und
- mindestens ein Druckwerkzeugteil (120), das das mindestens eine verschiebbare Element (125) umfasst,
wobei die Bauteilbearbeitungsvorrichtung so konfiguriert ist, dass das Bauteilhaltewerkzeugteil und das Druckwerkzeugteil relativ zueinander positioniert sind, um im Betrieb eine Kraft auf das mindestens eine Bauteil (10) auszuüben, das durch das mindestens eine verschiebbare Element in der/den jeweiligen Bauteilhalteposition(en) gehalten wird.

12. Bauteilbearbeitungsvorrichtung nach dem vorhergehenden Anspruch, wobei das Bauteilhaltewerkzeugteil (110) so konfiguriert ist, dass es ein darunter liegendes Element (11), wie z. B. ein Trägersubstrat, einen Leiterrahmen, eine Kühlplatte, ein Wechselrichtergehäuse usw. hält, das das mindestens eine Bauteil (10) trägt.

13. Bauteilbearbeitungsvorrichtung nach einem der beiden vorhergehenden Ansprüche, wobei die Bauteilbearbeitungsvorrichtung ein oberes Druckwerkzeugteil (120T) und ein unteres Druckwerkzeugteil (120B) umfasst, die auf gegenüberliegenden Seiten des Bauteilhaltewerkzeugteils (110) angeordnet sind, um das Ausüben einer Kraft auf ein jeweiliges des mindestens einen oder mehreren Bauteile, die in einer jeweiligen Bauteilhalteposition auf dem Bauteilwerkzeugteil gehalten werden, auf gegenüberliegende Seiten des jeweiligen einen Bauteils durch gegenüberliegende verschiebbare Elemente (125T, 125B) des oberen bzw. unteren Druckwerkzeugteils zu ermöglichen.

14. Drucksintervorrichtung, wobei die Drucksintervorrichtung die Bauteilverarbeitungsvorrichtung nach einem der vorhergehenden Ansprüche ist.

15. Bauteilverkapselungsvorrichtung, wobei die Bauteilverkapselungsvorrichtung die Bauteilbearbeitungsvorrichtung nach einem der vorhergehenden Ansprüche ist.

## Revendications

1. Appareil de traitement de composant (100) définissant au moins une position de maintien de composant pour maintenir un composant (10), tel qu'il comprend au moins un élément parmi une puce semi-conductrice, un substrat, une plaque de refroidissement, un boîtier, un boîtier d'onduleur, un espaceur, et comprenant au moins un élément déplaçable (125) associé à chaque position de maintien de composant, chaque élément déplaçable étant configuré et agencé pour permettre d'exercer un effort sur un composant maintenu dans la position de maintien de composant associée, l'appareil de traitement de composant (100) étant **caractérisé en ce qu'**il comprend au moins une partie d'appareil qui est sensible à la contrainte induite par la force, en cours d'utilisation, exercée par l'un ou plusieurs éléments déplaçables sur l'un ou plusieurs composants respectifs maintenus dans l'une ou plusieurs positions de maintien de composant, et qui a un capteur de contrainte (210) de réseau de Bragg sur fibre, FBG, où le capteur de contrainte FBG est configuré et agencé de façon fixe mécaniquement à la partie d'appareil respective pour permettre de mesurer la contrainte de la partie d'appareil respective telle qu'induite par la force, en utilisation, exercée par ledit élément déplaçable sur le(s) composant(s) respectif(s).

2. Appareil de traitement de composant selon la revendication précédente,
où au moins l'une de ladite partie d'appareil ayant le capteur de contrainte FBG (210), a un capteur de température (220) de réseau de Bragg sur fibre, FBG, et où le capteur de température FBG est configuré et agencé thermiquement en contact avec la partie d'appareil respective permettant de mesurer la température de la partie d'appareil respective tout en n'étant pas sensible à la contrainte dans la partie d'appareil respective, en particulier le capteur de température FBG étant agencé mécaniquement isolé de la partie d'appareil respective.

3. Appareil de traitement de composant selon l'une quelconque des revendications précédentes, où le capteur de contrainte FBG (210) a été fixé mécaniquement à ladite partie d'appareil respective par un processus de frittage sans pression.

4. Appareil de traitement de composant selon la revendication précédente,
où au moins un élément parmi le capteur de contrainte FBG (210) et une section applicable de ladite partie d'appareil respective a été revêtus d'un matériau comprenant un métal précieux, comme de l'argent ou de l'or, éventuellement une pâte ou une pellicule de frittage d'argent ou d'or, et ensuite chauffé pour fournir une liaison par frittage sans pression entre le capteur de contrainte FBG et ladite partie d'appareil respective.

5. Appareil de traitement de composant selon l'une quelconque des revendications précédentes, où le capteur de contrainte FGB (210) est agencé dans un canal (125.1) prévu dans ladite partie d'appareil respective.

6. Appareil de traitement de composant selon l'une quelconque des revendications précédentes lorsqu'elles dépendent de la revendication 2, où le capteur de température FGB (220) est agencé dans un canal (125.1) prévu dans ladite partie d'appareil respective.

7. Appareil de traitement de composant selon l'une quelconque des deux revendications précédentes, où le canal (125.1) est une rainure prévue sur un côté de ladite partie d'appareil respective, éventuellement où ladite partie d'appareil respective comprend deux sous-parties d'appareil ayant des côtés en butée mutuelle pourvus de rainures correspondantes (125.1a) fournissant le canal (125.1).

8. Appareil de traitement de composant selon l'une quelconque des revendications précédentes, où ladite partie d'appareil ayant le capteur de contrainte FBG (210) comprend un ou plusieurs dudit élément déplaçable (125).

9. Appareil de traitement de composant selon l'une quelconque des revendications précédentes, où ladite partie d'appareil ayant le capteur de contrainte FBG (210) comprend une partie de support d'un support pour les composants.

10. Appareil de traitement de composant selon l'une quelconque des revendications précédentes lorsqu'elles dépendent de la revendication 2, où le capteur de contrainte FBG (210) et le capteur de température FBG (220) qui sont fournis dans une seule partie d'appareil respective sont compris dans une seule fibre optique (200).

11. Appareil de traitement de composant selon l'une quelconque des revendications précédentes, où l'appareil de traitement de composant comprend
- une partie d'outil de maintien de composant (110) définissant ladite position de maintien de composant pour maintenir un composant ; et
- au moins une partie d'outil de pression (120) comprenant ledit élément déplaçable (125),
l'appareil de traitement de composant étant configuré pour avoir ou permettre d'avoir la partie d'outil de maintien de composant et la partie d'outil de pression positionnées l'une par rapport à l'autre pour exercer, en fonctionnement, une force sur au moins un composant (10) maintenu dans la ou les positions respectives de maintien de composant par ledit élément déplaçable.

12. Appareil de traitement de composant selon la revendication précédente, où la partie d'outil de maintien de composant (110) est configurée pour maintenir un élément sous-jacent (11), tel qu'un substrat de support, une grille de connexion, une plaque de refroidissement, un boîtier d'onduleur, etc., portant ledit composant (10).

13. Appareil de traitement de composant selon l'une quelconque des deux revendications, où l'appareil de traitement de composant comprend une partie d'outil de pression supérieure (120T) et une partie d'outil de pression inférieure (120B) agencées sur des côtés opposés de la partie d'outil de maintien de composant (110) pour permettre d'exercer une force sur l'un desdits respectifs composants maintenu dans une position respective de maintien de composant sur la partie d'outil de composant sur des côtés opposés respectifs dudit composant par des éléments déplaçables opposés (125T, 125B) des parties d'outil de pression supérieure et inférieure, respectivement.

14. Appareil de frittage sous pression, où l'appareil de frittage sous pression est l'appareil de traitement de composant selon l'une quelconque des revendications précédentes.

15. Appareil d'encapsulation de composant, où l'appareil d'encapsulation de composant est l'appareil de traitement de composant selon l'une quelconque des revendications précédentes.
